# EUROPÄISCHE PATENTANMELDUNG

(11) **EP 1 213 747 A1**
(43) Veröffentlichungstag der Anmeldung: **12.06.2002**
(21) Anmeldenummer: 01128095.5
(22) Anmeldetag: 27.11.2001
(51) Int. Cl.: H01L 21/00

(54) **Vorrichtung und Verfahren zum Ergreifen und Transportieren von Wafern**

(30) Priorität: 11.12.2000 DE 10061628
(71) Anmelder: Leica Microsystems Semiconductor GmbH, 35578 Wetzlar (DE)
(72) Erfinder: Mainberger, Robert, 35619 Braunfels (DE); Hahn, Kurt, 35394 Giessen (DE)
(74) Vertreter: Reichert, Werner F., Dr.

(57) **Zusammenfassung**

Die Erfindung betrifft eine Vorrichtung zum Ergreifen und Transportieren von Wafern (1) mit einer um einen zentralen Drehpunkt (13) schwenkbaren zweiarmigen Greifvorrichtung (7), an deren beiden freien Enden mit Vakuumansaugvorrichtungen (11) versehene Greif- / Halteelemente (12) angeordnet sind. Um eine Vorrichtung der eingangs genannten Art sowie eine mit einer solchen Vorrichtung versehene Transportanordnung bereitzustellen, die einen schnelleren Transport der Wafer (1) ohne lange Totzeiten und somit eine Erhöhung des Gesamtdurchsatzes der Anordnung ermöglicht, wird erfindungsgemäß vorgeschlagen, dass die beiden Arme (10) der Greifvorrichtung (7) unter einem Winkel (α) von 90° < α < 180° gegeneinander abgewinkelt sind.

Die Erfindung betrifft weiterhin eine mit einer solchen Vorrichtung versehene vollständige Transportanordnung sowie ein Verfahren zum Betreiben dieser Transportanordnung.

## Beschreibung

Die Erfindung betrifft eine Vorrichtung zum Ergreifen und Transportieren von Wafern mit einer um einen zentralen Drehpunkt schwenkbaren zweiarmigen Greifvorrichtung, an deren beiden freien Enden mit Vakuumansaugvorrichtungen versehene Greif- / Halteelemente angeordnet sind. Die Erfindung betrifft weiterhin eine mit einer solchen Vorrichtung versehene vollständige Transportanordnung sowie ein Verfahren zum Betreiben dieser Transportanordnung.

In der Mikroelektronik werden zur Chipherstellung nach der Halbleiterblocktechnik Wafer genannte einkristalline Halbleiterscheiben verwendet. Auf diesen unter Reinstraumbedingungen hergestellten Wafern wird eine Vielzahl von integrierten Schaltkreisen hergestellt. Um die Wafer während der Herstellung und Überprüfung von einer Lager- oder Bearbeitungsstation zur nächsten zu transportieren, werden sie in Kassetten aufbewahrt. Zur Entnahme der Wafer aus den Kassetten werden in der Regel mit Vakuum-Ansaugvorrichtungen versehene Greifvorrichtungen verwendet. Die Greifvorrichtungen legen die jeweils entnommenen Wafer zur weiteren Handhabung auf Ablagepositionen ab.

Bei den aus der Praxis bekannten Wafer-Transportvorrichtungen werden zum Transport der Wafer zwischen zwei Ablagepositionen jeweils zweiarmige Greifvorrichtungen (auch als Waferwechsler bezeichnet) verwendet, die um einen zentralen Drehpunkt schwenkbar sind. Die beiden Arme dieser bekannten Greifvorrichtungen sind um 180° zueinander versetzt um den Drehpunkt angeordnet, das heißt, sie liegen auf einer Achse. An den beiden freien Enden der Arme sind Greif- / Halteelemente mit Vakuum-Ansaugvorrichtungen angeordnet. Eine solche Greifvorrichtung ist beispielsweise aus der US 5,229,615 A bekannt.

Um einen Wafer zu ergreifen und zu einer anderen Ablageposition zu bewegen und/oder anschließend mit dem anderen Ende der Greifvorrichtung einen anderen Wafer von der gleichen Ablageposition zu entnehmen, ist es jeweils notwendig, die Greifvorrichtung um 180° zu schwenken. Dieser große Schwenkwinkel sowie die beim Transport anfallenden Totzeiten, in denen die Greifvorrichtung still steht, da kein zu ergreifender Wafer vorliegt, bedeuten bei der Chipherstellung einen teuren Zeitverlust.

Ausgehend von diesem Stand der Technik liegt der Erfindung die Aufgabe zugrunde, eine Vorrichtung der eingangs genannten Art sowie eine mit einer solchen Vorrichtung versehene Transportanordnung bereitzustellen, die einen schnelleren Transport der Wafer ohne lange Totzeiten und somit eine Erhöhung des Gesamtdurchsatzes der Anordnung ermöglicht. Ferner liegt der Erfindung die Aufgabe zugrunde, ein Verfahren zum Betreiben dieser Transportanordnung bereitzustellen.

Die vorrichtungsmäßige Lösung dieser Aufgabenstellung wird erfindungsgemäß dadurch gelöst, dass die beiden Arme des Waferwechslers unter einem Winkel von 90° < α < 180° gegeneinander abgewinkelt sind.

Durch die erfindungsgemäße Verkleinerung des zwischen den beiden Armen der Greifvorrichtung aufgespannten Winkels ist es möglich, die Verstellzeit zum Ergreifen des nächsten Wafers deutlich zu reduzieren. Besonders vorteilhaft ist dabei, wenn der zwischen den Armen aufgespannte Winkel so ausgebildet ist, dass sich dieser Winkel auch in der Anordnung der Aufnahmeund Ablagepositionen für die Wafer wiederfindet. Auf diese Weise ist es auf jeden Fall ausreichend, die Greifvorrichtung um maximal den Winkelbetrag zu schwenken, der dem zwischen den beiden Armen aufgespannten Winkel entspricht.

Gemäß einer ersten praktischen Ausführungsform der Erfindung beträgt der Winkel zwischen den beiden Armen der Greifvorrichtung 120°. Die Verwendung des Winkels von 120° ist besonders vorteilhaft, da bei dieser Winkelstellung eine Transportanordnung mit drei Ablage- bzw. Aufnahmepositionen für die Wafer verwendet werden kann, wobei die einzelnen Ablage- bzw. Aufnahmepositionen um jeweils 120° zueinander versetzt angeordnet sind, so dass mittels der Greifvorrichtung immer zwei der drei Ablage- bzw. Aufnahmepositionen gleichzeitig erreichbar sind.

Bei dieser Ausbildung ist die Greifvorrichtung zwischen zwei Auslenkungspositionen um maximal 2 x 120° hin und zurück um den Drehpunkt schwenkbar. Durch Schwenken der Greifvorrichtung um 2 x 120° ergibt sich dabei die Möglichkeit, drei Aufnahme- bzw. Ablagepositionen anzusteuern.

Gemäß einer zweiten praktischen Ausführungsform der Erfindung beträgt der Winkel zwischen den beiden Armen der Greifvorrichtung 135°. Bei dieser Ausbildung ist die Greifvorrichtung zwischen zwei Auslenkungspositionen um maximal 135° hin und zurück um den Drehpunkt schwenkbar. Ausgehend von einer Ruhestellung der Greifvorrichtung ist es möglich, den maximalen Schwenkbereich der Greifvorrichtung um den Drehpunkt auf maximal 1/2 x 135° je Richtung zu beschränken, so dass schon nach kürzester Schwenkungsdauer die nächste Aufnahme- bzw. Ablageposition erreichbar ist.

Weiterhin wird mit der Erfindung vorgeschlagen, dass die Endpunkte des jeweiligen Schwenkbereichs der Greifvorrichtung durch Anschläge begrenzt sind.

Selbstverständlich ist es bei einer erfindungsgemäß ausgebildeten Vorrichtung auch möglich, dass die Greifvorrichtung unbegrenzt um den Drehpunkt schwenkbar ist. In diesem Fall wird gänzlich auf Anschläge zur Begrenzung der Schwenkbewegung verzichtet.

Eine erfindungsgemäße Transportanordnung zum Transportieren von Wafern zwischen zwei Stationen, insbesondere einem Wafermagazin und einer Prüfvorrichtung, mit mindestens einer Wafer-Aufbewahrungsstation, einem Roboterarm zum Ent- und/oder Beladen der Wafer-Aufbewahrungsstation, einer Zwischenablage für die Wafer, einer Wafer-Bearbeitungsstation und einer Greifvorrichtung zum Transportieren der Wafer von der Zwischenablage zur Wafer-Bearbeitungsstation und zurück ist zur Lösung der Aufgabenstellung gekennzeichnet durch eine zweite Zwischenablage zwischen der Wafer-Aufbewahrungsstation und der Wafer-Bearbeitungsstation, wobei die eine Zwischenablage als Ablage für den Transport zur Wafer-Bearbeitungsstation und die andere Zwischenablage als Ablage für den Rücktransport fort von der Wafer-Bearbeitungsstation dient.

Durch die Verwendung von zwei Zwischenablagen ist es möglich, den mit der Transportanordnung erzielbaren Durchsatz deutlich zu erhöhen, da sich die Totzeiten für die Greifvorrichtung und den Roboterarm verringern.

Gemäß einer bevorzugten Ausführungsform der Erfindung ist die für den Transport zur Wafer-Bearbeitungsstation dienende Zwischenablage als Vorausrichtstation ausgebildet, auf der eine erste Ausrichtung des Wafers stattfindet, bevor dieser mittels der Greifvorrichtung einer Wafer-Bearbeitungsstation zugeführt wird. Diese kann beispielsweise als ein Mikroskop mit einem X-Y-Tisch oder ein Koordinaten-Messgerät oder ein Strukturbreiten-Messgerät ausgebildet sein.

Um die Schwenkwinkel der Greifvorrichtung zum Aufnehmen bzw. Ablegen der Wafer von bzw. auf den Zwischenablagen auf ein Minimum zu reduzieren, wird erfindungsgemäß vorgeschlagen, dass die beiden Zwischenablagen relativ zum Drehpunkt der Greifvorrichtung unter dem von den beiden Armen der Greifvorrichtung definierten Winkel α und auf einem von den Enden der beiden Arme festgelegten Schwenkkreis angeordnet sind.

Das erfindungsgemäße Verfahren zum Transportieren von Wafern zwischen zwei Stationen, insbesondere einem Wafermagazin und einer Prüfvorrichtung, mittels einer erfindungsgemäßen Transportanordnung mit mindestens einer Wafer-Aufbewahrungsstation, einem Roboterarm zum Ent- und/oder Beladen der Wafer-Aufbewahrungsstation, einer Zwischenablage für die Wafer, einer Wafer-Bearbeitungsstation und einer Greifvorrichtung zum Transportieren der Wafer von der Zwischenablage zur Wafer-Bearbeitungsstation und zurück ist gekennzeichnet durch die Verfahrensschritte:
1. Herausnehmen eines ersten Wafers aus einer Wafer-Aufbewahrungsstation und Ablegen dieses ersten Wafers auf der ersten Zwischenablage mittels des Roboterarms;
2. Ergreifen des auf der ersten Zwischenablage gelagerten ersten Wafers mittels der Greifvorrichtung und Übergabe dieses ersten Wafers an die Wafer-Bearbeitungsstation und Schwenken der Greifvorrichtung in eine Ruhestellung, während gleichzeitig das Herausnehmen eines zweiten Wafers aus der Wafer-Aufbewahrungsstation erfolgt;
3. Ablegen des zweiten Wafers auf der wieder freien ersten Zwischenablage mittels des Roboterarms und Schwenken der Greifvorrichtung in die Ruheposition;
4. Verfahren des Roboterarms in eine Parkposition unterhalb der zweiten Zwischenablage und gleichzeitiges Ergreifen des auf der Wafer-Bearbeitungsstation abgelegten ersten Wafers sowie des auf der ersten Zwischenablage abgelegten zweiten Wafers mittels der Greifvorrichtung;
5. Ablegen des ersten Wafers auf der zweiten Zwischenablage und Ablegen des zweiten Wafers auf der Wafer-Bearbeitungsstation;
6. Schwenken der Greifvorrichtung in eine Ruhestellung;
7. Ergreifen des auf der zweiten Zwischenablage abgelegten ersten Wafers durch Anheben des unterhalb der zweiten Zwischenablage geparkten Roboterarms und
8. Ablegen des von der zweiten Zwischenablage aufgenommenen ersten Wafers in der Wafer-Aufbewahrungsstation.

Durch das Verwenden der zweiten Zwischenablage sowie das Parken des Roboterarms unterhalb der zweiten Zwischenablage anstatt im Bereich der Wafer-Aufbewahrungsstation, wie dies aus dem Stand der Technik bekannt ist, wird insbesondere im achten Verfahrensschritt Zeit im Sekundenbereich eingespart, was zu einer Erhöhung des mit dieser Transportanordnung erzielbaren Durchsatzes von über 10 % führt.

Schließlich wird mit dem erfindungsgemäßen Verfahren vorgeschlagen, dass bei der Ausbildung der ersten Zwischenablage als Vorausrichtstation (sogenannte Pre-Alignment-Station) nach dem ersten Verfahrensschritte und/oder während des vierten Verfahrensschritts gleichzeitig eine Vorausrichtung der auf der ersten Zwischenablage abgelegten Wafer erfolgt. Dadurch entfallen die Zeiten für das Prealignment in die ohnehin aufgewendeten Zeiten für die genannten Verfahrensschritte und fallen nicht extra als Maschinenlaufzeiten an. Dadurch wird das erfindungsgemäße Verfahren noch effektiver nutzbar.

Weitere Merkmale und Vorteile der Erfindung ergeben sich anhand der nachfolgenden Beschreibung der zugehörigen Zeichnung, in der zwei Ausführungsbeispiele einer erfindungsgemäßen Transportanordnung beispielhaft schematisch dargestellt sind. Es zeigen:
- ***Fig. 1:***: eine Draufsicht auf eine erste Ausführungsform einer erfindungsgemäßen Transportanordnung;
- ***Fig. 2:***: eine Draufsicht auf eine zweite Ausführungsform einer erfindungsgemäßen Transportanordnung;
- ***Fig. 3:***: eine schematische Darstellung der Greifvorrichtung in der Ruhestellung;
- ***Fig. 4:***: eine schematische Darstellung der Greifvorrichtung im Eingriff mit der ersten Zwischenablage;
- ***Fig. 5:***: eine schematische Darstellung der Greifvorrichtung im Eingriff mit der zweiten Zwischenablage und
- ***Fig. 6a - 6i:***: Darstellung der von der Transportanordnung durchgeführten Verfahrensschritte.

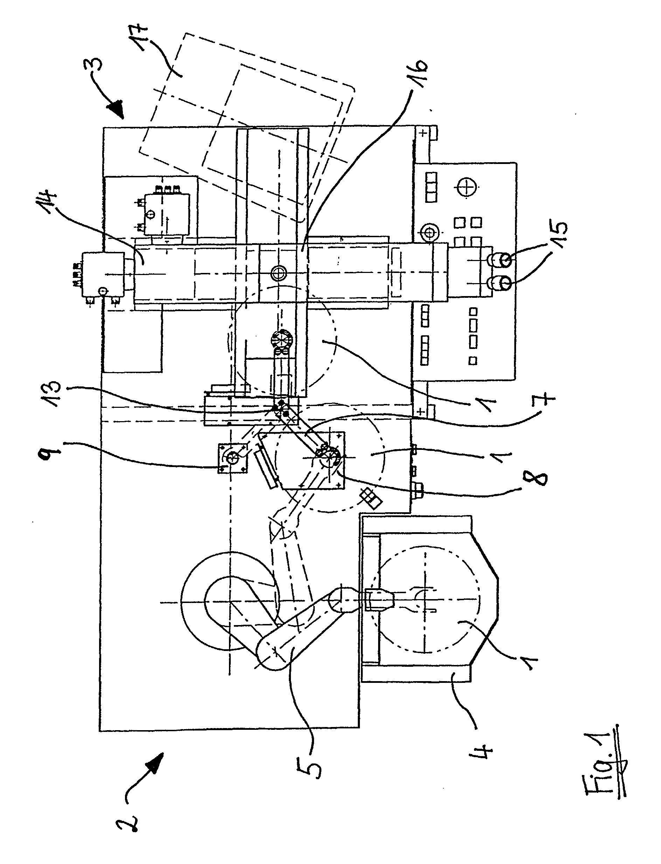

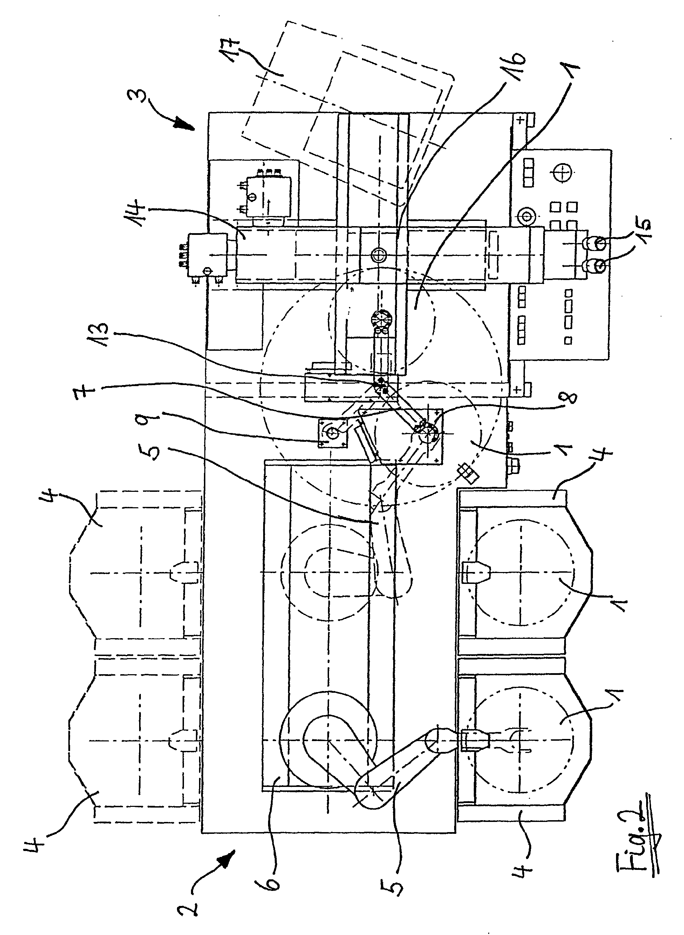

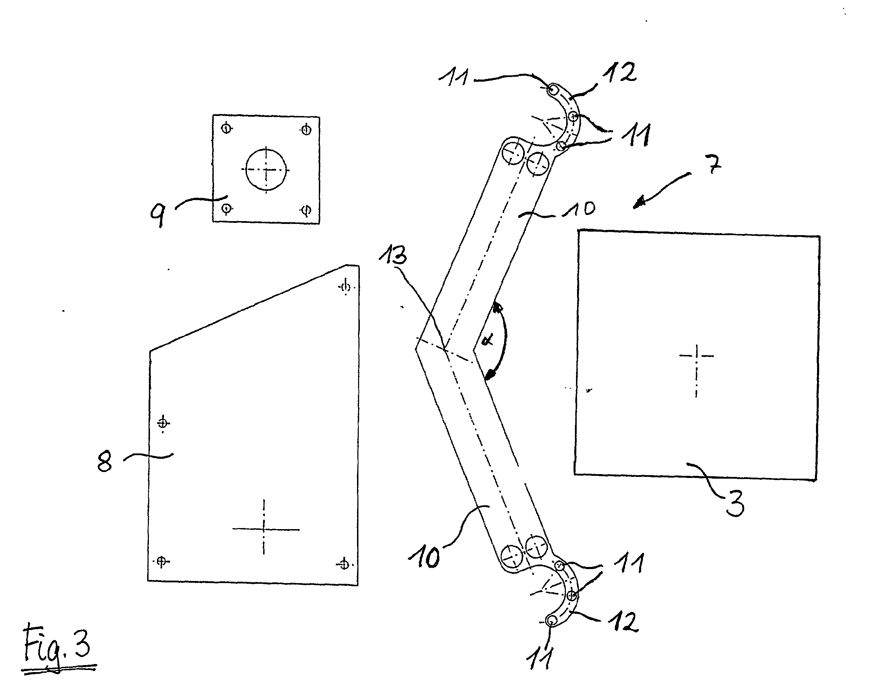

Die Abbildungen ***Fig. 1*** und ***Fig. 2*** zeigen Draufsichten auf Transportanordnungen zum Transportieren von Wafern 1 von einer Wafer-Aufbewahrungsstation 2 zu einer Wafer-Bearbeitungsstation 3 und zurück. Die beiden dargestellten Transportanordungen unterscheiden sich darin, dass die Wafer-Aufbewahrungsstation 2 gemäß ***Fig. 1*** ein Magazin 4 zum Lagern der Wafer 1 aufweist, während die Wafer-Aufbewahrungsstation 2 gemäß ***Fig. 2*** mit vier Magazinen 4 ausgestattet ist. Um mittels eines Roboterarms 5 alle Magazine 4 zum Be- und Entladen mit Wafern erreichen zu können, ist der Roboterarm 5 der Transportanordnung gemäß ***Fig. 2*** zusätzlich entlang einer zwischen den Magazinen 4 verlaufenden Führung 6 verfahrbar.

Neben der Verwendung des Roboterarms 5 zum Be- und Entladen des Magazins 4 bzw. der Magazine 4 der Wafer-Aufbewahrungsstation 2 erfolgt der Transport der Wafer 1 hin zur Wafer-Bearbeitungsstation 3 und wieder zurück unter Verwendung einer Greifvorrichtung 7 sowie zweier zwischen der Wafer-Aufbewahrungsstation 2 und der Wafer-Bearbeitungsstation 3 angeordneter Zwischenablagen 8 und 9, wobei die erste Zwischenablage 8 für den Transport der Wafer 1 hin zur Wafer-Bearbeitungsstation 3 und die zweite Zwischenablage 9 für den Transport der Wafer 1 fort von der Wafer-Bearbeitungsstation 3 verwendet wird.

Die Wafer-Bearbeitungsstation 3 in dem hier dargestellten Beispiel umfasst ein Mikroskop 14 mit Okularen 15 und einem Mikroskoptisch 16 zum Auflegen eines zu untersuchenden Wafers 1. Das Mikroskopbild wird zusätzlich mittels einer Videokamera (nicht dargestellt) aufgenommen und auf einem Monitor 17 dargestellt.

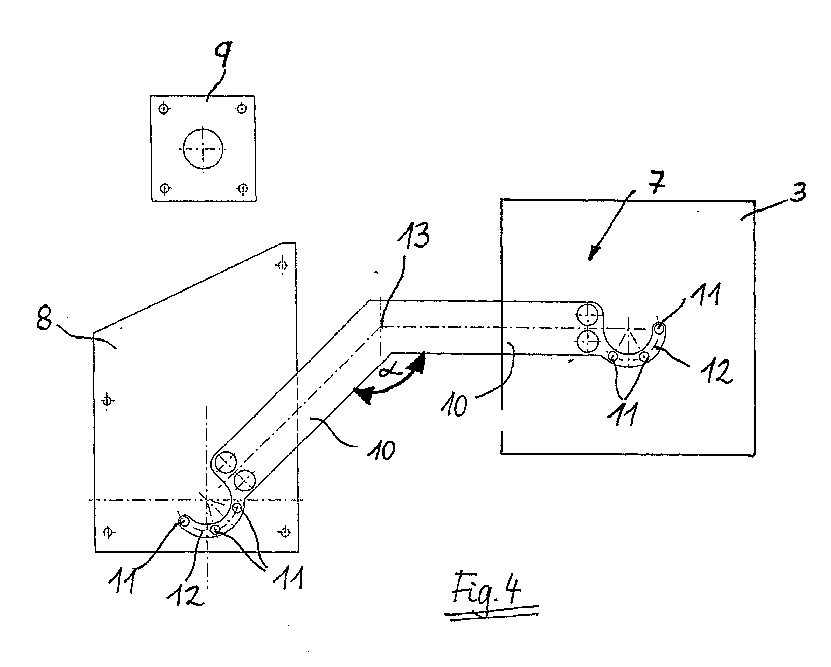

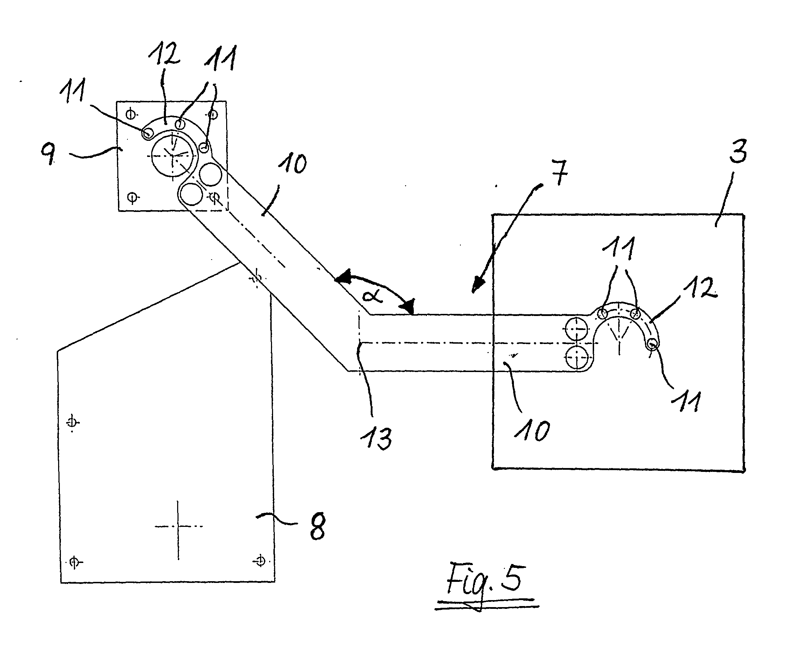

Der Aufbau sowie die Arbeitsweise der Greifvorrichtung 7 ist genauer den Abbildungen ***Fig. 3, 4, 5*** und ***Fig. 6a - 6i*** zu entnehmen.

Die Greifvorrichtung 7 weist zwei Arme 10 auf, die zwischen sich einen Winkel α von 90° < α < 180° aufspannen. An den beiden freien Enden weisen die Arme 10 mit Vakuumansaugvorrichtungen 11 versehene Greif- / Halteelemente 12 auf, über die die zu transportierenden Wafer 1 ergriffen werden können. Zum Transport der Wafer 1 von den Zwischenablage 8 fort bzw. zur Zwischenablage 9 hin, ist die Greifvorrichtung 7 um einen zentralen Drehpunkt 13 schwenkbar.

Das Transportieren der Wafer 1 von der Wafer-Aufbewahrungsstation 2 fort hin zur Wafer-Bearbeitungsstation 3 und wieder zurück geschieht mit der dargestellten Transportanordnung wie nachfolgend beschrieben.

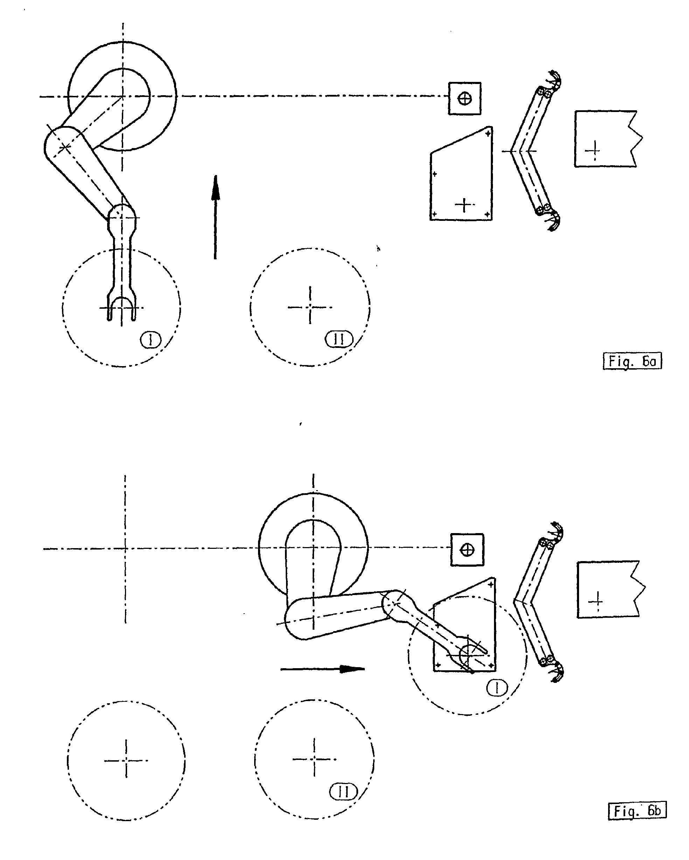

Vor Beginn des ersten Verfahrensschritts befindet sich die Greifvorrichtung 7 in der in ***Fig. 3*** dargestellten Ruhestellung. Die Einstellung der gesamten Transportanordnung vor dem ersten Verfahrensschritt zeigt ***Fig. 6a.***

Im **ersten Verfahrensschritt** entnimmt der Roboterarm 5 einem Magazin 4 der Wafer-Aufbewahrungsstation 2 einen Wafer I und legt diesen auf der ersten Zwischenablage 8 ab. Bei der Transportanordnung gemäß ***Fig. 2*** kann es notwendig sein, dass der Roboterarm 5 zum Entnehmen des ersten Wafers I aus dem Magazin 4 zunächst entlang der Führung 6 verfahren werden muß, bis er das entsprechende Magazin 4 erreicht hat. Ebenso ist es dann nach dem Entnehmen des ersten Wafers I notwendig, den Roboterarm 5 wieder in Richtung der Zwischenablagen 8, 9 zu verfahren, damit der erste Wafer I abgelegt werden kann. Dieser Verfahrensschritt wird verdeutlicht in ***Fig. 6a*** und ***6b.***

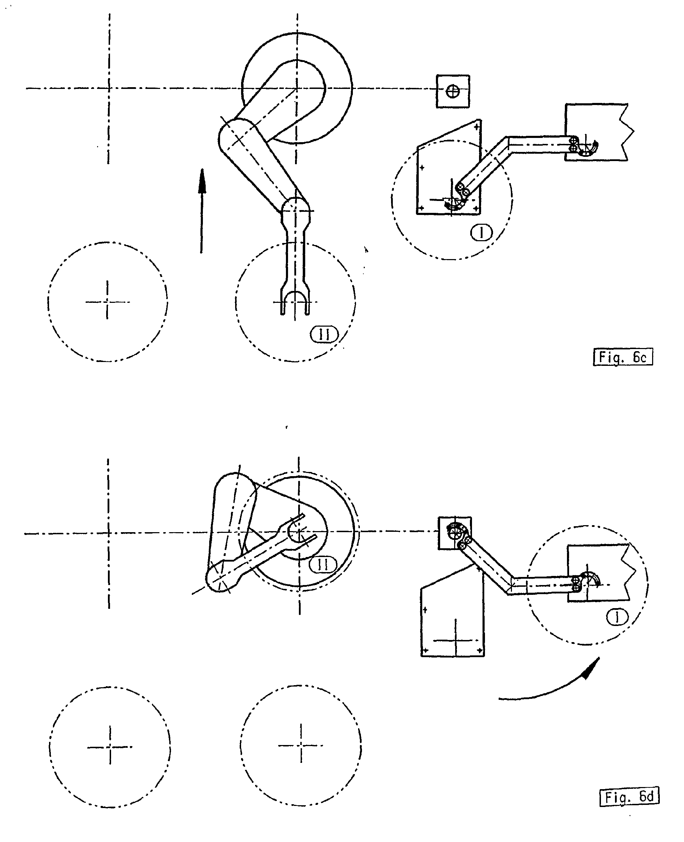

In einem **zweiten Verfahrensschritt** wird der auf der ersten Zwischenablage 8 gelagerte erste Wafer I mit einem Greif- / Halteelement 12 der Greifvorrichtung 7 ergriffen, wie in ***Fig. 6c*** dargestellt. Nach Drehen der Greifvorrichtung 7 um den Winkel α in Richtung der Wafer-Bearbeitungsstation 3 wird der erste Wafer I auf dieser Wafer-Bearbeitungsstation 3 abgelegt. Die Stellung der Greifvorrichtung 7 beim Ablegen des ersten Wafers I auf der Wafer-Bearbeitungsstation 3 ist in ***Fig. 6d*** dargestellt.

Der erste Wafer I kann nun auf der Wafer-Bearbeitungsstation 3 geprüft, vermessen oder anderweitig bearbeitet werden. Bei der Wafer-Bearbeitungsstation 3 kann es sich beispielsweise um ein Mikroskop 14 zum Vermessen und Überprüfen der integrierten Schaltungen des ersten Wafers I handeln. In diesem Fall ist es vorteilhaft, wenn die erste Zwischenablage 8 als Vorausrichtstation (Prealigner) ausgebildet ist, um den Wafer I (bzw. später die jeweils aufgelegten Wafer) für ein exaktes Auflegen auf den X-Y-Tisch vorzubereiten.

Während des Greifens und Ablegens des ersten Wafers I wird mit dem Roboterarm 5 ein zweiter Wafer II aus der Wafer-Aufbewahrungsstation 2 entnommen, wie in ***Fig. 6c*** gezeigt.

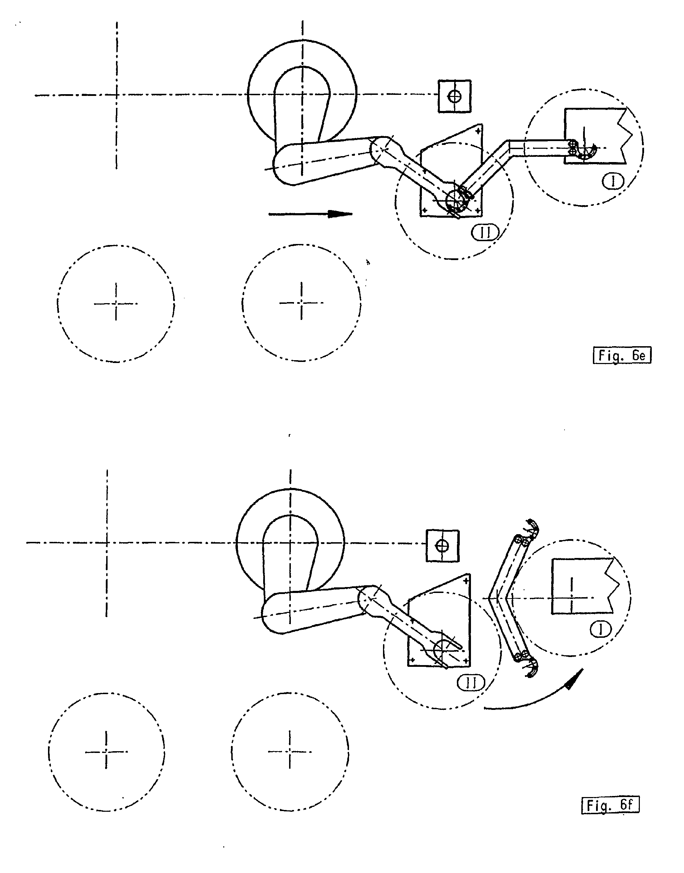

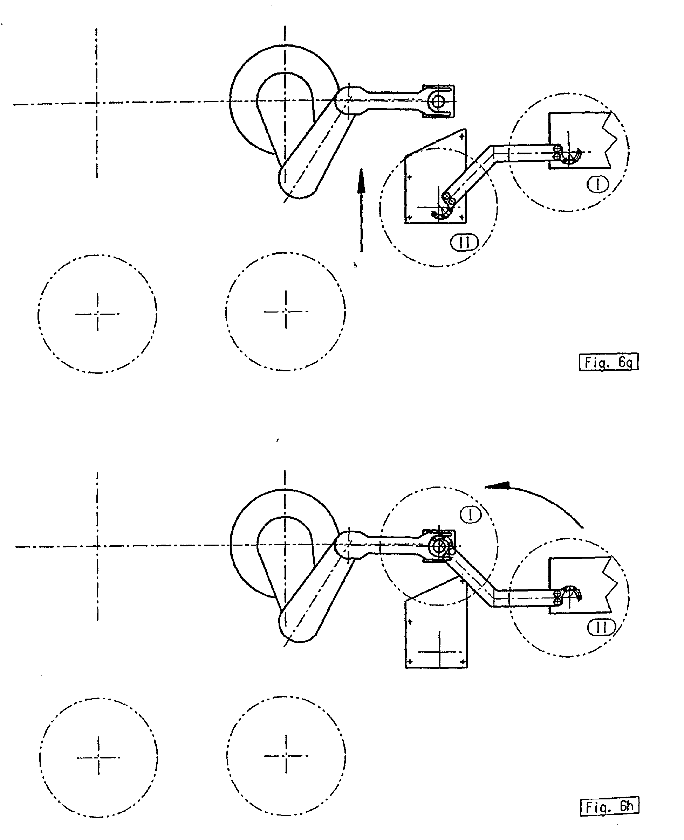

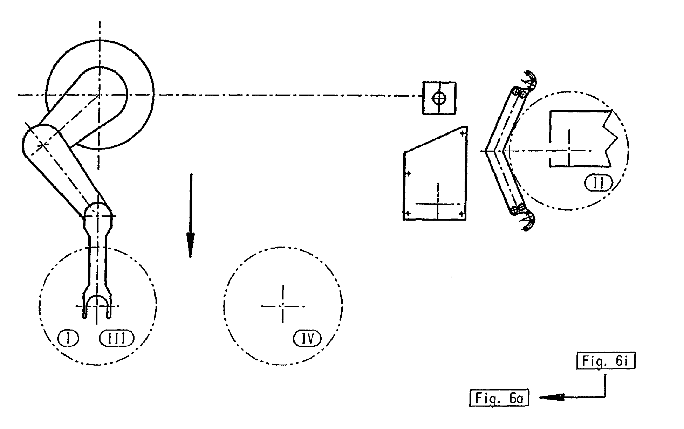

In einem **dritten Verfahrensschritt** wird der aufgenommene zweite Wafer II mittels des Roboterarms 5 auf der jetzt wieder freien ersten Zwischenablage 8 abgelegt, wie in ***Fig. 6e*** dargestellt, während gleichzeitig die Greifvorrichtung 7 um den Drehpunkt 13 wieder in die in ***Fig. 3*** dargestellte Ruhestellung geschwenkt wird, wie in ***Fig. 6 f*** dargestellt ist.

Anschließend wird der Roboterarm 5 in eine Parkposition unterhalb der zweiten, noch unbelegten Zwischenablage 9 verfahren, wie in ***Fig. 6g*** gezeigt ist. Auf diese Weise befindet sich der Roboterarm außerhalb des Schwenkbereichs der Greifvorrichtung 7, um Kollisionen zu vermeiden.

In einem **vierten Verfahrensschritt** wird die Greifvorrichtung 7 aus der in ***Fig. 6e*** dargestellten Ruhestellung in die in ***Fig. 6g*** dargestellte Position geschwenkt und in dieser Position angehoben. Dabei werden gleichzeitig der auf der Wafer-Bearbeitungsstation 3 abgelegte erste Wafer I sowie der auf der ersten Zwischenablage 8 abgelegte zweite Wafer II mittels der beiden Greif- / Halteelemente 12 der Greifvorrichtung 7 ergriffen. Dies ist dargestellt in ***Fig. 6g.***

In einem **fünften Verfahrensschritt** wird die solchermaßen mit den beiden Wafern I und II bestückte Greifvorrichtung 7 in die Position gemäß ***Fig. 6h*** geschwenkt und legt den ersten Wafer 1 auf der zweiten Zwischenablage 9 und den zweiten Wafer 1 auf der Wafer-Bearbeitungsstation 3 ab. In diesem Verfahrensschritt werden die beiden ergriffenen Wafer I und II zeitgleich transportiert und abgelegt, wodurch das Verfahren sehr schnell abläuft.

Anschließend wird in einem **sechsten Verfahrensschritt** die Greifvorrichtung 7 mit den freien Greif- / Halteelementen 12 wieder in die in ***Fig. 6i*** dargestellte Ruhestellung geschwenkt.

In einem **siebenten Verfahrensschritt** wird der Roboterarm 5 aus seiner Parkposition unterhalb der zweiten Zwischenablage 9 angehoben und dabei der auf der zweiten Zwischenablage 9 abgelegte erste Wafer I ergriffen. Dieser Schritt erfordert ebenfalls nur sehr kurze Zeit.

In einem **achten Verfahrensschritt** legt der Roboterarm 5 den solchermaßen aufgenommenen ersten Wafer I nun zurück in ein Magazin 4 der Wafer-Aufbewahrungsstation 2, wie in ***Fig. 6i*** dargestellt.

Daran anschließend beginnt der gesamte Verfahrensablauf mit dem ersten Verfahrensschritt und der Entnahme eines dritten Wafers III von vorne. Der bereits in der Transportanordnung befindliche zweite Wafer II wird beim Abarbeiten der Verfahrensschritte automatisch mit der Greifvorrichtung 7 von der Wafer-Bearbeitungsstation 3 zu der zweiten Zwischenablage 9 transportiert, dort von dem Roboterarm 5 aufgenommenen und zurück in ein Magazin 4 der Wafer-Aufbewahrungsstation 2 gelegt.

In einer vorteilhaften Ausgestaltung des erfindungsgemäßen Verfahrens wird jeweils während des zweiten Verfahrensschritts und des sechsten Verfahrensschritts eine Vorausrichtung der auf der ersten Zwischenablage 8 abgelegten Wafer 1 vorgenommen.

Eine solchermaßen ausgebildete Transportanordnung zeichnet sich dadurch aus, dass der Durchsatz insbesondere aufgrund des Parkens des Roboterarms 5 unterhalb der zweiten Zwischenablage 9 sowie der Ausbildung des Winkels α, mit 90 < α < 180°, zwischen den beiden Armen 10 der Greifvorrichtung 7 deutlich, das heißt um über 10 %, gesteigert werden kann. Durch die Wahl des Winkelmaßes für den Winkel *α* verkürzt sich die Schwenkzeit der Greifvorrichtung 7 von einer Position in die nächste.

### Bezugszeichenliste

- 1: Wafer
- 2: Wafer-Aufbewahrungsstation
- 3: Wafer-Bearbeitungsstation
- 4: Magazin
- 5: Roboterarm
- 6: Führung
- 7: Greifvorrichtung
- 8: erste Zwischenablage
- 9: zweite Zwischenablage
- 10: Arm
- 11: Vakuumansaugvorrichtung
- 12: Greif- / Haltevorrichtung
- 13: Drehpunkt
- 14: Mikroskop
- 15: Okulare
- 16: Mikroskoptisch
- 17: Monitor

- I: erster Wafer
- II: zweiter Wafer
- III: dritter Wafer

- α: Winkel

## Patentansprüche

1. Vorrichtung zum Ergreifen und Transportieren von Wafern mit einer um einen zentralen Drehpunkt (13) schwenkbaren zweiarmigen Greifvorrichtung (7), an deren beiden freien Enden mit Vakuumansaugvorrichtungen (11) versehene Greif- / Halteelemente (12) angeordnet sind,
**dadurch gekennzeichnet,**
**dass** die beiden Arme (10) der Greifvorrichtung (7) unter einem Winkel (α) von 90° < α < 180° gegeneinander abgewinkelt sind.

2. Vorrichtung nach Anspruch 1, **dadurch gekennzeichnet,**
**dass** der Winkel (α) zwischen den beiden Armen (10) der Greifvorrichtung (7) 120° beträgt.

3. Vorrichtung nach Anspruch 1, **dadurch gekennzeichnet,**
**dass** der Winkel (α) zwischen den beiden Armen (10) der Greifvorrichtung (7) 135° beträgt.

4. Vorrichtung nach Anspruch 2, **dadurch gekennzeichnet,**
**dass** die Greifvorrichtung (7) zwischen zwei extremen Auslenkungspositionen um maximal 2 x α hin und zurück um den Drehpunkt (13) schwenkbar ist.

5. Vorrichtung nach Anspruch 3, **dadurch gekennzeichnet,**
**dass** die Greifvorrichtung (7) ausgehend von einer Ruhestellung um maximal 1/2 x 135° hin und zurück um den Drehpunkt (13) schwenkbar ist.

6. Transportanordnung zum Transportieren von Wafern zwischen zwei Stationen, insbesondere einem Wafermagazin und einer Prüfvorrichtung, mit mindestens einer Wafer-Aufbewahrungsstation (2), einem Roboterarm (5) zum Ent- und/oder Beladen der Wafer-Aufbewahrungsstation (2), einer Zwischenablage (8) für die Wafer (1), einer Wafer-Bearbeitungsstation (3) und einer Greifvorrichtung (7), insbesondere nach einem der Ansprüche 1 bis 5, zum Transportieren der Wafer (1) von der Zwischenablage (8) zur Wafer-Bearbeitungsstation (3) und zurück,
**gekennzeichnet durch**
eine zweite Zwischenablage (9) zwischen der Wafer-Aufbewahrungsstation (2) und der Wafer-Bearbeitungsstation (3), wobei die eine Zwischenablage (8) als Ablage für den Transport zur Wafer-Bearbeitungsstation (3) und die andere Zwischenablage (9) als Ablage für den Rücktransport fort von der Wafer-Bearbeitungsstation (3) dient.

7. Transportanordnung nach Anspruch 6, **dadurch gekennzeichnet, dass** die für den Transport zur Wafer-Bearbeitungsstation (3) dienende Zwischenablage (8) als Vorausrichtstation ausgebildet ist.

8. Transportanordnung nach Anspruch 6 oder 7,
**dadurch gekennzeichnet,**
**dass** die beiden Zwischenablagen (8, 9) relativ zum Drehpunkt (13) der Greifvorrichtung (7) unter dem von den beiden Armen (10) der Greifvorrichtung (7) definierten Winkel (α) und auf einem von den Enden der beiden Arme (10) festgelegten Schwenkkreis angeordnet sind.

9. Verfahren zum Transportieren von Wafern zwischen zwei Stationen, insbesondere einem Wafermagazin und einer Prüfvorrichtung, mittels einer Transportanordnung, insbesondere nach mindestens einem der Ansprüche 6 bis 8, mit mindestens einer Wafer-Aufbewahrungsstation (2), einem Roboterarm (5) zum Ent- und/oder Beladen der Wafer-Aufbewahrungsstation (2), einer Zwischenablage (8) für die Wafer (1), einer Wafer-Bearbeitungsstation (3) und einer Greifvorrichtung (7), insbesondere nach einem der Ansprüche 1 bis 5, zum Transportieren der Wafer (1) von der Zwischenablage (8) zur Wafer-Bearbeitungsstation (3) und zurück,
**gekennzeichnet durch**
die Verfahrensschritte:
a) Herausnehmen eines ersten Wafers (I) aus einer Wafer-Aufbewahrungsstation (2) und Ablegen dieses ersten Wafers (I) auf der ersten Zwischenablage (8) mittels des Roboterarms (5);
b) Ergreifen des auf der ersten Zwischenablage (8) gelagerten ersten Wafers (I) mittels der Greifvorrichtung (7), Übergeben dieses ersten (I) an die Wafer-Bearbeitungsstation (3) und Schwenken der Greifvorrichtung (7) in eine Ruhestellung, während gleichzeitig das Herausnehmen eines zweiten Wafers (II) aus der Wafer-Aufbewahrungsstation (3) erfolgt;
c) Ablegen des zweiten Wafers (II) auf der ersten Zwischenablage (8) mittels des Roboterarms (5) und Schwenken der Greifvorrichtung (7) in die Ruheposition;
d) Verfahren des Roboterarms (5) in eine Parkposition unterhalb der zweiten Zwischenablage (9) und gleichzeitiges Ergreifen des auf der Wafer-Bearbeitungsstation (3) abgelegten ersten Wafers (I) sowie des auf der ersten Zwischenablage (8) abgelegten zweiten Wafers (II) mittels der Greifvorrichtung (7);
e) Ablegen des ersten Wafers (I) auf der zweiten Zwischenablage (9) und Ablegen des zweiten Wafers (II) auf der Wafer-Bearbeitungsstation (3);
f) Schwenken der Greifvorrichtung (7) in eine Ruhestellung;
g) Ergreifen des auf der zweiten Zwischenablage (9) abgelegten ersten Wafers (I) **durch** Anheben des unterhalb der zweiten Zwischenablage (9) geparkten Roboterarms (5) und
h) Ablegen des von der zweiten Zwischenablage (9) aufgenommenen ersten Wafers (I) in der Wafer-Aufbewahrungsstation (2).

10. Verfahren nach Anspruch 12, wobei die ersten Zwischenablage (8) als Vorausrichtstation ausgebildet ist,
**dadurch gekennzeichnet,**
**dass** jeweils zwischen den Verfahrensschritt a) und b) oder während des Verfahrensschritts d) eine Vorausrichtung des jeweils auf der ersten Zwischenablage (8) abgelegten Wafers (1) erfolgt.
